Europäisches Patentamt

European Patent Office

Office européen des brevets

(11) Numéro de publication: **0 206 931**
**B1**

(12) FASCICULE DE BREVET EUROPEEN

(45) Date de publication du fascicule du brevet:
05.09.90

(51) Int. Cl.⁵: **G01R 33/24**

(21) Numéro de dépôt: 86401323.0

(22) Date de dépôt: 17.06.86

(54) Sonde de magnétomètre à RMN à cavité accordable en son centre et à galette centrale dédoublée.

(30) Priorité: 21.06.85 FR 8509488

(43) Date de publication de la demande:
30.12.86 Bulletin 86/52

(45) Mention de la délivrance du brevet:
05.09.90 Bulletin 90/36

(84) Etats contractants désignés:
DE GB NL SE

(56) Documents cités:
FR-A- 2 092 998
FR-A- 2 098 624

(73) Titulaire: COMMISSARIAT A L'ENERGIE ATOMIQUE,
29-31, rue de la Fédération, F-75015 Paris(FR)

(72) Inventeur: **Glenat, Henri, 14, Avenue de la Foy,**
**F-38700 Corenc(FR)**
Inventeur: **Kernevez, Nelly, 14, Boulevard Maréchal**
**Leclerc, F-38000 Grenoble(FR)**
Inventeur: **Sonrel, Claude, Domaine des Angonnes,**
**F-38320 Brie et Angonnes(FR)**

(74) Mandataire: **Mongrédien, André et al, c/o**
**BREVATOME 25, rue de Ponthieu, F-75008 Paris(FR)**

### Description

La présente invention a pour objet une sonde de magnétomètre à résonance magnétique nucléaire (RMN en abrégé). Elle trouve une application dans la mesure précise des champs magnétiques, notamment du champ magnétique terrestre dont la valeur est de $5.10^{-5}$ Tesla ou encore 50 000 gammas, le gamma étant une unité particulièrement commode dans l'application envisagée (1 gamma = $10^{-9}$.Tesla).

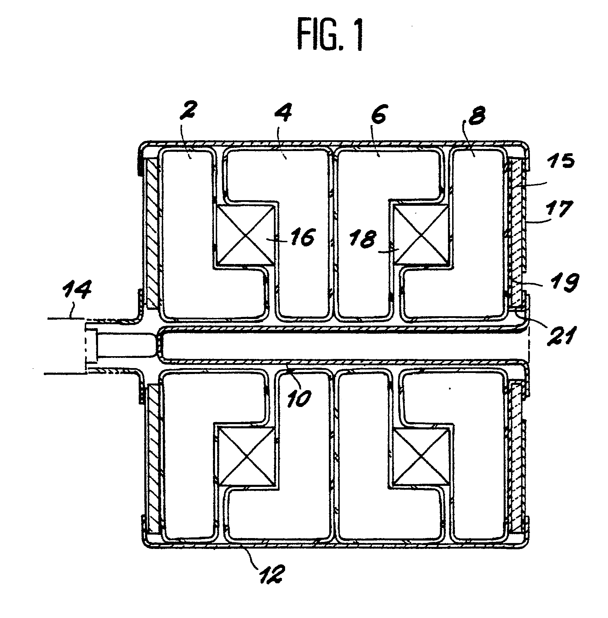

Le magnétomètre dans lequel est utilisée l'invention est du type oscillateur à couplage de spin sans axe interdit. Un tel dispositif est connu et est décrit notamment dans les demandes de brevets français FR-A-1 447 226 et FR-A 2 098 624. Il n'est donc pas utile de décrire en détail un tel dispositif. Il suffit de rappeler que cet appareil comprend (conformément à la figure 1) au moins deux échantillons liquides contenus dans des flacons (4 dans la variante illustrée, soit 2, 4, 6, 8) ces flacons étant disposés dans une cavité résonnante en très haute fréquence. Cette cavité est constituée par un conducteur central 10 et une paroi extérieure conductrice 12, ce conducteur central et cette paroi sont connectés à un câble coaxial 14 relié à un générateur VHF non représenté. La sonde comprend encore des enroulements 16, 18 de prélèvement et de réinjection d'un signal à la fréquence de LARMOR définie, d'une part, par le champ magnétique dans lequel baigne la sonde et, d'autre part, par le rapport gyromagnétique propre aux échantillons utilisés.

A ce sujet il faut encore rappeler que le terme "échantillon" désigne une masse de solvant présentant des noyaux atomiques à moment magnétique et à moment cinétique non nuls, donc à rapport gyromagnétique bien défini. Ce solvant contient en solution, une substance paramagnétique possédant au moins une raie de résonance électronique saturable.

Cette raie de résonance est excitée par le champ de très haute fréquence (VHF), établi dans la cavité résonnante. Comme la fréquence de résonance de cette cavité ne peut être prévue avec suffisamment de précision, on utilise un élément accordable, qui est en général capacitif, et qui permet, en laboratoire, un ajustage de la fréquence de résonance.

Dans l'art antérieur rappelé plus haut et notamment dans le document FR-A-2 098 624, l'élément capacitif réglable présente la forme illustrée sur la partie droite de la figure 1. Il s'agit d'un disque 15, par exemple en quartz, percé d'un trou central et revêtu, sur la face externe, de secteurs argentés 17 reliés à la paroi extérieure conductrice 12. Ces secteurs ne s'étendent pas jusqu'au trou central du disque. Sur la face interne, le disque est revêtu de secteurs argentés de faible épaisseur 19, disposés en regard des secteurs 17. Les secteurs 19 sont reliés entre eux par un dépôt métallique 21 qui recouvre le trou central et sert en même temps de liaison avec le conducteur central 10.

Ainsi constitué, cet ensemble joue le rôle de condensateur, les secteurs 17 et 19 en constituant les armatures et le disque en quartz 15 le diélectrique. Ce condensateur est inséré entre le conducteur central 10 et la paroi extérieure 12 de la cavité.

L'ajustage de ce condensateur permet donc le réglage de la fréquence de résonance de la cavité. Pour cela l'opérateur gratte plus ou moins l'argenture 17 recouvrant le disque 15.

S'il donne satisfaction à certains égards, ce moyen de réglage présente néanmoins des inconvénients. En effet, tout d'abord, il est très lié à la forme des flacons utilisés, qui, comme on peut le voir sur la figure 1, présentent une forme cylindrique. Or, tel n'est pas toujours le cas puisque les formes peuvent être très diverses et, être par exemple hémisphériques. Par ailleurs, le dispositif est essentiellement dissymétrique, puisqu'il est placé à une extrémité de la sonde. Il est également assez complexe et cher puisqu'il requiert un disque en quartz recouvert de secteurs argentés. Enfin, et comme on le comprendra mieux par la suite, la présence inévitable d'une bulle dans le flacon d'extrémité vient perturber le réglage lorsque la sonde est en position verticale, surtout dans le cas des flacons hémisphériques.

La présente invention a justement pour but de remédier à ces inconvénients en proposant un moyen d'accord beaucoup plus simple, moins coûteux, symétrique et insensible à la position des bulles dans les flacons.

Selon l'invention, l'élément capacitif de réglage est constitué par au moins un condensateur réglable disposé au centre de la cavité, entre deux moitiés du conducteur central de la cavité, l'extrémité du demi-tronçon du conducteur central qui n'est pas relié au coaxial étant reliée directement à la paroi extérieure conductrice par un court-circuit.

De toutes façons, les caractéristiques de l'invention apparaîtront mieux après la description qui suit, d'exemples de réalisation donnés à titre explicatif et nullement limitatif. Cette description se réfère à des dessins annexés sur lesquels :

- la figure 1, déjà décrite, illustre l'art antérieur,
- la figure 2 représente une variante à deux flacons hémisphériques et à quatre bobines,
- la figure 3 montre un flacon hémisphérique dans deux positions verticales,
- la figure 4 illustre une autre variante de réalisation à quatre flacons et à deux bobines.

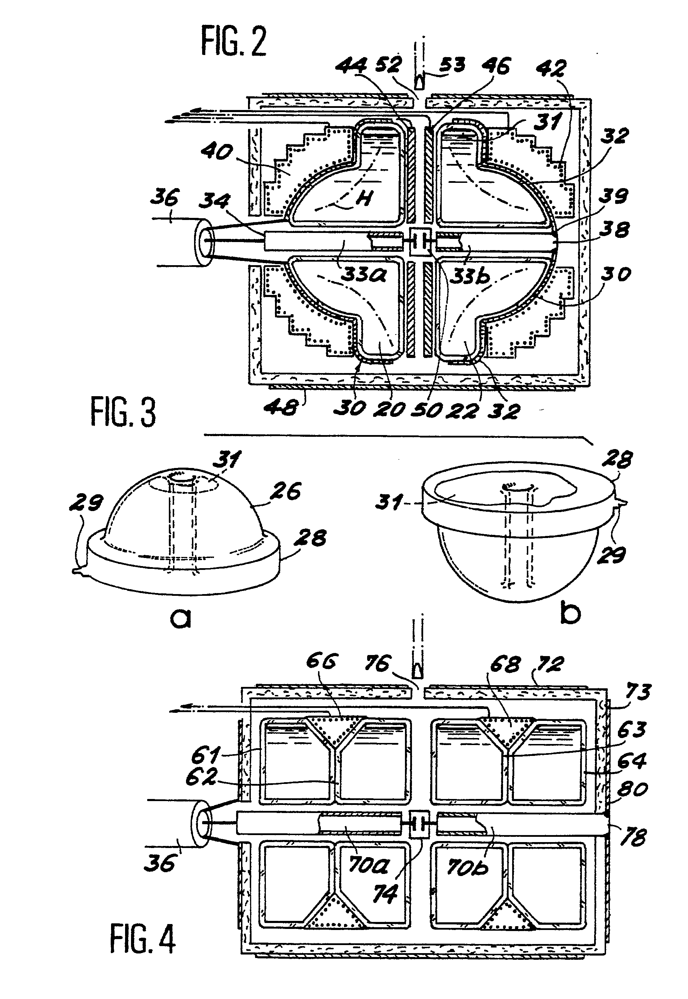

La sonde représentée sur 1 figure 2 comprend deux flacons 20, 22 constitués chacun (comme on peut mieux le voir sur la figure 3) par un hémisphère 26 et une galette cylindrique 28. Ces deux flacons sont revêtus extérieurement par une couche métallique argentée respectivement 30, 32, constituée de bandes non jointives (pour éviter les courants de Foucault circonférentiels). La sonde comprend encore un conducteur central formé de deux demi-tronçons 33a et 33b, l'extrémité gauche 34 du tronçon 33a étant reliée au conducteur central d'un coaxial 36 et l'extrémité droite 38 du tronçon 33b étant connectée à la couche conductrice 32 du flacon 22 par des bandes conductrices 39.

Les enroulements de prélèvement et d'excitation de cette sonde comprennent, d'une part, deux enroulements hémisphériques 40 et 42 et, d'autre part, deux bobines plates 44 et 46. Les enroulements hémisphériques 40 et 42 sont obtenus par bobinage sur un gabarit sphérique et imprégnation par une résine. La forme en escaliers présentée par les zones extérieures vient de ce que des spires qui seraient situées dans ces zones participeraient peu à l'excitation et au prélèvement du signal de mesure et ont donc été supprimées, ce qui allège d'autant la sonde.

Les enroulements 40 et 42, d'une part, 44 et 46, d'autre part, sont bobinés et connectés de telle sorte que les signaux utiles s'ajoutent et les signaux parasites se retranchent, comme expliqué dans les documents précédemment cités. La forme particulière donnée aux enroulements de la figure 2 conduit à un champ magnétique schématisé par la ligne H. Il résulte de cette forme que, quelle que soit l'orientation de la sonde par rapport au champ à mesurer, il existe toujours un volume de l'échantillon pour lequel le champ d'excitation n'est pas parallèle au champ à mesurer, ce qui évite tout axe interdit de mesure.

La sonde représentée se complète par un blindage extérieur 48 formé par des bandes métalliques déposées sur un support isolant.

Conformément à l'invention, un condensateur réglable 50 est disposé entre les tronçons 33a et 33b du conducteur central. Ce condensateur est accessible de l'extérieur grâce à une ouverture 52 pratiquée dans le blindage. Une tige ou l'extrémité d'un tournevis 53 permet d'ajuster manuellement la valeur de la capacité du condensateur en passant entre les deux flacons 20, 22 et entre les deux bobines plates 44 et 46.

Naturellement, étant situé dans la cavité résonnante et étant soumis au champ magnétique à mesurer, le condensateur 50 doit être rigoureusement amagnétique.

On observera la parfaite symétrie du dispositif de la figure 2 et sa simplicité. En outre, il présente un autre intérêt qui peut être souligné en liaison avec la figure 3. Un flacon y est représenté avec sa partie hémisphérique 26 et sa galette cylindrique 28. Le remplissage s'effectue par un queusot 29 qui, une fois scellé, constitue une petite protubérance sur le côté du flacon. Le remplissage du flacon n'est, en fait, jamais total car, pour permettre la dilatation du liquide, il est nécessaire de prévoir une bulle 31. Lorsque le flacon se présente verticalement, la partie hémisphérique en haut (partie a de la figure 3), la bulle 31 se place au sommet de l'hémisphère et occupe une superficie relativement réduite. Dans la sonde, cela signifie que cette bulle se trouve autour de l'extrémité 38 du conducteur central. Dans l'art antérieur, c'est justement cette extrémité qui servait à ajuster la fréquence de la cavité, de sorte qu'en position verticale la cavité se trouvait déréglée. Cet inconvénient est évité avec l'invention puisque le condensateur de réglage est situé au centre de la cavité.

Naturellement, lorsqu'on considère la position inversée (partie b), la bulle vient au contact de la paroi plane de la galette du flacon 20, à proximité de la zone de réglage ; mais, dans ce cas, la surface offerte à la bulle 31 est grande et celle-ci est dont très mince, ce qui n'a pratiquement aucun effet sur le réglage.

L'invention ne s'applique pas uniquement aux sondes à flacons hémisphériques, mais à tout type de sonde. La figure 4 montre en particulier une sonde à quatre flacons 61, 62, 63, 64 dans lesquels les échantillons sont répartis 2 à 2 comme expliqué dans les documents antérieurs ; deux enroulements 66 et 68 sont disposés entre les flacons. La cavité résonnante est formée, d'une part, par un conducteur central formé de deux demi-tronçons 70a et 70b et, d'autre part, par une paroi conductrice formée de bandes argentées 72 sur la partie cylindrique de la sonde et de secteurs argentés 73 sur les deux parois latérales.

Selon l'invention, un condensateur réglable 74, amagnétique, est connecté entre les deux demi-tronçons 70a et 70b. Ce condensateur est accessible de l'extérieur de la sonde à travers une ouverture 76 pratiquée dans la couche extérieure, un espace étant ménagé, à cet effet, entre les flacons 62 et 63. L'extrémité 78 du tronçon 70b est électriquement reliée par une feuille métallique 80 aux secteurs 73 de la paroi latérale de droite.

## Revendications

1. Sonde de magnétomètre à résonance magnétique nucléaire à couplage de spin sans axe interdit, cette sonde comprenant au moins deux échantillons liquides contenus dans au moins deux flacons (20, 22, 61, 62, 63, 64), ces flacons étant disposés dans une cavité résonnante en très haute fréquence, cette cavité étant constituée par un conducteur central (33a, 33b, 70a, 70b) et une paroi extérieure conductrice (30, 72), le conducteur central étant relié à un élément capacitif permettant le réglage de la fréquence de résonance de la cavité ledit conducteur central et ladite paroi étant connectés à un câble coaxial relié à un générateur VHF, la sonde comprenant encore au moins deux enroulements (40, 42, 66, 68) de prélèvement et de réinjection d'un signal à la fréquence de LARMOR définie par le champ magnétique dans lequel baigne la sonde et par le rapport gyromagnétique propre aux échantillons utilisés, ces enroulements entourant au moins une partie des échantillons ; cette sonde étant caractérisée par le fait que l'élément capacitif de réglage est constitué par au moins un condensateur réglable (50, 74) disposé au centre de la cavité, entre deux demi-tronçons du conducteur central (33a, 33b, 70a, 70b), l'extrémité (38, 78) du demi-tronçon (33b, 70b) du conducteur central qui n'est pas relié au câble coaxial étant reliée à la paroi extérieure conductrice par un court-circuit (39, 80).

2. Sonde selon la revendication 1, caractérisée par le fait qu'elle comprend une paroi extérieure recouverte de bandes métallisées formant soit la paroi extérieure de la cavité (72), soit un blindage (48), cette paroi étant percée d'une ouverture (52, 76) permettant d'accéder au condensateur pour le régler manuellement de l'extérieur.

3. Sonde selon la revendication 1, caractérisée par le fait que le condensateur réglable (50, 74) est amagnétique.

4. Sonde selon la revendication 1, caractérisée par le fait qu'elle comprend deux flacons (20, 22) ayant chacun la forme d'un hémisphère (26) accolé à une galette cylindrique plate (28), les deux flacons (20, 22) étant disposés en regard l'un de l'autre, leurs galettes plates se faisant face, les flacons ayant leur paroi extérieure recouverte de bandes conductrices formant la paroi extérieure de la cavité résonnante, le condensateur de réglage (50) étant disposé entre les deux galettes des deux flacons (20, 22).

5. Sonde selon la revendication 4, caractérisée par le fait qu'elle comprend deux premiers enroulements (40, 42) chacun bobiné sur une surface hémisphérique concentrique à la partie hémisphérique (26) des flacons (20, 22), et deux seconds enroulements (44, 46) en forme de bobines plates disposées entre les deux galettes plates (28), ces deux enroulements participant à la récupération du signal et améliorant l'isotropie de la sonde, le condensateur réglable (50) étant disposé entre les deux seconds enroulements (44, 66).

## Claims

1. Spin coupling nuclear magnetic resonance magnetometer probe without forbidden axis, said probe comprising at least two liquid samples contained in at least two bottles (20, 22, 61, 62, 63, 64), said bottles being placed in a very high frequency resonant cavity, which is constituted by a central conductor (33a, 33b, 70a, 70b), and an outer conductive wall (30, 72), the central conductor being connected to a capacitive element permitting the regulation of the resonant frequency of the cavity, said central conductor and said wall being connected to a coaxial cable connected to a VHF generator, the probe also comprising two windings (40, 42, 66, 68) for sampling and reinjecting a signal at the LARMOR frequency defined by the magnetic field in which the probe is located and by the gyromagnetic ratio of the samples used, said winding surrounding at least part of the samples, characterized in that the capacitive regulating element is constituted by at least one regulatable capacitor (50, 74) located in the centre of the cavity between two half-sections of the central conductor (33a, 33b, 70a, 70b), one end (38, 78) of the half-section (33b, 70b) of the central conductor which is not connected to the coaxial cable being connected to the outer conductive wall by a short-circuit (39, 80).

2. Probe according to claim 1, characterized in that it comprises an outer wall covered with metallized strips forming either the outer wall of the cavity (72), or a shielding (48), said wall having an opening (52, 76) giving access to the capacitor for the manual regulation thereof from the outside.

3. Probe according to claim 1, characterized in that the regulatable capacitor (50, 74) is amagnetic.

4. Probe according to claim 1, characterized in that it comprises two bottles (20, 22), each being shaped like a hemisphere (26) joined to a flat cylindrical member (28), the two bottles (20, 22) facing one another, their flat cylindrical members facing one another, the bottles having the external wall thereof covered by conductive strips forming the outer wall of the resonant cavity, the regulating capacitor (50) being located between the two cylindrical members of the two bottles (20, 22).

5. Probe according to claim 4, characterized in that it comprises two first windings (40, 42), each wound on to a hemispherical surface concentric to the hemispherical part (26) of the bottles (20, 22) and two second windings (44, 46) in the form of flat coils placed between the two flat cylindrical members (28), said two windings participating in the recovery of the signal and the improvement of the isotropy of the probe, the regulatable capacitor (50) being positioned between the two second windings (44, 66).

## Patentansprüche

1. Magnetometersonde für Kernspinresonanz mit Spinkopplung ohne verbotene Achse, wobei diese Sonde zwei flüssige, in wenigstens zwei Fläschchen (20, 22, 61, 62, 63, 64) enthaltene Proben aufweist, wobei diese Fläschchen in einem Resonanzhohlraum für sehr hohe Frequenzen angeordnet sind, wobei dieser Hohlraum aus einem zentralen Leiter (33a, 33b, 70a, 70b) und einer äußeren, leitfähigen Wand (30, 72) besteht, wobei der zentrale Leiter mit einem kapazitiven Element verbunden ist, das die Regulierung der Resonanzfrequenz des Hohlraums erlaubt, wobei der zentrale Leiter und die Wand mit einem mit einem VHF-Generator verbundenen Kabel verbunden sind, wobei die Sonde außerdem wenigstens zwei Wicklungen (40, 42, 66, 68) zum Abgreifen und zum Rückkoppeln eines Signals mit der durch das Magnetfeld, in dem die Sonde eingetaucht ist, und durch das den benutzten Proben eigene gyromagnetische Verhältnis bestimmten LARMOR-Frequenz, wobei diese Wicklungen wenigstens einen Teil der Proben umgeben; wobei diese Sonde gekennzeichnet ist durch die Tatsache, daß das kapazitive Regelelement aus wenigstens einem regelbaren Kondensator (50, 74) besteht, der im Zentrum des Hohlraums zwischen zwei Halbstümpfen des zentralen Leiters (33a, 33b, 70a, 70b) angeordnet ist, wobei das Ende (38, 78) des Halbstumpfes (33b, 70b) des zentralen Leiters, der nicht mit dem Koaxialkabel verbunden ist, mit der äußeren, leitfähigen Wand über einen Kurzschluß (39, 80) verbunden ist.

2. Sonde nach Anspruch 1, gekennzeichnet durch die Tatsache, daß sie eine mit metallisierten Bändern bedeckte Wand aufweist, die entweder die äußere Wand des Hohlraums (72) oder eine Abschirmung bilden, wobei diese Wand von einer Öffnung (52, 76) durchstoßen wird, die ermöglicht, an den Kondensator zu seiner manuellen Regelung von außen heranzukommen.

3. Sonde nach Anspruch 1, gekennzeichnet durch die Tatsache, daß der regelbare Kondensator (50, 74) unmagnetisch ist.

4. Sonde nach Anspruch 1, gekennzeichnet durch die Tatsache, daß sie zwei Fläschchen (20, 22) aufweist, die jeweils die Form einer an eine zylinderförmige, flache Scheibe (28) angehängten Halbkugel (26) besitzen, wobei die beiden Fläschchen (20, 22) einander gegenüber angeordnet sind, wobei sich die Scheiben gegenüberstehen, wobei die äußere Wand der Fläschchen von leitfähigen Bändern bedeckt sind, die die äußere Wand des Hohlraums bilden, wobei der regelbare Kondensator (50) zwischen den beiden Scheiben der beiden Fläschchen (20, 22) angeordnet ist.

5. Sonde nach Anspruch 1–4, gekennzeichnet durch die Tatsache, daß sie zwei erste Wicklungen (40, 42), die jeweils auf einer halbkugelförmigen, mit dem halbkugelförmigen Teil (26) der Fläschchen konzentrischen Oberfläche gewickelt sind, und zwei zweite Wicklungen (44, 46) in der Form flacher, zwischen den beiden flachen Scheiben (28) angeordneter Spulen aufweist, wobei diese beiden Wicklungen an dem Abgreifen des Signals mitwirken und die Isotropie der Sonde verbessern, wobei der regelbare Kondensator (50) zwischen den beiden zweiten Wicklungen (44, 66) angeordnet ist.

# FIG. 1

FIG. 2

FIG. 3

a

b

FIG. 4